## Europäisches Patentamt
## European Patent Office
## Office européen des brevets

(19)

(11) Veröffentlichungsnummer: **0 105 083**
**B1**

(12) **EUROPÄISCHE PATENTSCHRIFT**

(45) Veröffentlichungstag der Patentschrift:
**08.04.87**

(21) Anmeldenummer: **83104867.3**

(22) Anmeldetag: **17.05.83**

(51) Int. Cl.⁴: **H 05 K 7/02,** H 05 K 7/20,
H 01 R 23/72

(54) **Flachbaugruppe.**

(30) Priorität: **30.09.82 DE 3236325**

(43) Veröffentlichungstag der Anmeldung:
**11.04.84 Patentblatt 84/15**

(45) Bekanntmachung des Hinweises auf die Patenterteilung:
**08.04.87 Patentblatt 87/15**

(84) Benannte Vertragsstaaten:
**AT BE CH DE FR GB IT LI NL**

(56) Entgegenhaltungen:
**EP-A-0 030 763**
**DE-A-2 253 400**
**DE-A-2 446 081**
**FR-A-2 378 423**
**US-A-4 045 105**
**US-A-4 089 575**
**US-A-4 346 952**

(73) Patentinhaber: **Siemens Aktiengesellschaft Berlin und München, Wittelsbacherplatz 2, D-8000 München 2 (DE)**

(72) Erfinder: **Der Erfinder hat auf seine Nennung verzichtet**

EP 0 105 083 B1

## Beschreibung

Die Erfindung betrifft eine Flachbaugruppe, bestehend aus einer mit elektrischen Bausteinen bestückten Leiterplatte, aus einem Steckverbinderteil mit einer Vielzahl von Kontaktelementen und aus einem, einen Druck auf eine Leiterplattenfläche ausübenden Andruckbauteil, beispielsweise einer Kühleinrichtung.

Beim Aufbau von großen elektronischen Systemen, wie beispielsweise Datenverarbeitungsanlagen, ist man bestrebt, möglichst kurze Signalleitungen mit einem definierten Wellenwiderstand zu erhalten und damit hohe Schaltgeschwindigkeiten zu erzielen. Das kann mit Hilfe von Flachbaugruppen erreicht werden, die ein- oder mehrlagige Leiterplatten mit integrierten Bausteinen aufweisen, und die über elektrische Steckverbinder mit einer Verdrahtungsplatte verbunden sind. Diese ist, um eine hohe Leiterdichte zu erreichen, ebenfalls mehrlagig ausgeführt und enthält Signalleitungen zum Verbinden von Baugruppen untereinander, aber auch Potential-und Versorgungsleitungen. Bei Flachbaugruppen höchster Packungsdichte sind die dazu notwendigen zahlreichen Außenanschlüsse auf engstem Raum auf der Unterseite verteilt, um die Verbindung zur Leiterplatte ohne Umwege herzustellen.

Aus der US-PS 3 993 123 ist eine Flachbaugruppe mit wärmeabgebenden Bausteinen bekannt, die auf einer Seite einer Trägerplatte ankontaktiert sind. Sie liegen unter einer Kühleinrichtung, die sie wie eine Kappe umschließt, und von der aus ein oder mehrere federnde Teile ein wärmeableitendes Element auf jeden Baustein pressen. Der dabei erzeugte Druck wird auf die Plattenränder abgeleitet, die an der Kühleinrichtung angeflanscht sind, wobei der Träger jedoch eine Durchbiegung erfahren kann.

Da auch eine große Anzahl von senkrecht abstehenden Steckerstiften auf der Trägerplate befestigt ist, beeinträchtigt eine Durchbiegung das Einstecken und Ziehen der Flachbaugruppe, was bekanntlich genau parallel zueinander ausgerichtete Stifte erfordert. Im anderen Fall besteht die Gefahr, daß Stifte verbogen oder abgebrochen werden, und daß dadurch fehlerhafte Verbindungen entstehen, oder daß zumindest noch größere Steck-und Ziehkräfte aufgewendet werden müssen, als sie wegen der großen Zahl von Verbindungen ohnehin nötig sind. Außerdem besteht bei einer der mechanischen Spannung ausweichenden Leiterplatte die Gefahr, daß feine Risse in den betroffenen Leiterbahnen entstehen und die Verbindungen unterbrechen. Das kann umsomehr auch dann eintreten, wenn die Stifte fest mit der Leiterplatte verbunden sind, und die bereits bestehende Auslenkung bei häufigem Wechsel der Flachbaugruppe einerseits durch Ziehkräfte vergrößert und andererseits durch die Elastizität der Leiterplatte wieder zurückgestellt wird, was zu einer Ermüdung des Leiterbahnmaterials führen kann.

Der Erfindung lag daher die Aufgabe zugrunde, eine mit einem Steckverbinderteil versehene Flachbaugruppe der oben genannten Art in der Weise auszubilden, daß aus Steck- und Ziehvorgängen resultierende Fehlerquellen verringert werden. Diese Aufgabe wird dadurch gelöst, daß auf der dem Andruckbauteil gegenüberliegenden Seite der Leiterplatte Kontaktierungsflächen gleich mäßig verteilt angeordnet sind, daß sich das Steckverbinderteil über diese gesamte Seitenfläche erstreckt, und daß es oberhalb der Kontaktierungsflächen Durchbrüche für die Kontaktelemente aufweist, die jeweils aus einem Federschaft und aus einem als Druckfeder ausgebildeten, unter Federspannung an den Kontaktierungsflächen anliegenden Anschlußfahne bestehen. Auf diese Weise wirken keine einseitigen Druckkräfte auf die Leiterplatte, so daß keine Durchbiegung auftritt. Durch die Wahl der Federkonstanten der Anschlußfahnen ist der Gegendruck auf die Leiterplatte voreinstellbar. Da außerdem die Kontaktelemente nicht starr mit der Leiterplatte verbunden sind, führen die beim Stecken und Ziehen auftretenden Kräfte nicht zu einer Auslenkung der Leiterplatte. Dadurch werden Risse und Brüche in Leiterbahnen oder in Lötverbindungen, die von einer statischen oder dynamischen Krafteinwirkung herrühren, verhindert.

Nach einer Ausgestaltung der Erfindung sind die Anschlußfahnen als gekrümmte Blattfedern ausgebildet. Wenn die Anschlußfahnen fest mit den Kontaktierungsflächen verbunden sind, wird die Kontaktsicherheit erhöht, die sich weiter dadurch verbessern läßt, daß die Federschäfte jeweils aus drei U-förmig miteinander verbundenen, einen Aufnahmekanal für einen Kontaktstift bildenden Seitenteilen bestehen, und daß mindestens einer der U-Schenkel einen federnden Abschnitt zum Anpressen an den Kontaktstift aufweist.

Die Federschäfte der Kontaktelemente sind vorteilhafterweise jeweils durch eine Einschnappverriegelung in den Durchbrüchen des Steckverbinderteils fixiert. Werden die Anschlußfahnen bezüglich ihrer Abmessungen so ausgebildet, daß das gesamte Kontaktelement in einen Durchbruch steckbar ist, so kann eine Zuordnung von Verbindungselementen und von Anschlußflächen für unterschiedliche Flachbaugruppen wahlweise vorgenommen werden.

Nach Weiterbildungen der Erfindung ist die Leiterplatte in eine erste Aussparung des Steckverbinderteils und das Andruckbauteil in eine zweite Aussparung parallel zur Leiterplatte in das Steckverbinderteil eingepaßt. Das führt zu einem kompakten Aufbau der Flachbaugruppe und hat darüberhinaus den Vorteil, daß die gesamte Flachbaugruppe vom Steckverbinderteil eingefaßt ist, so daß es beim Stecken und Ziehen alle Kräfte aufnimmt.

Im folgenden wird die Erfindung anhand eines in zwei Figuren dargestellten Ausführungsbeispiels weiter erläutert.

Fig.1 zeigt eine Flachbaugruppe,

Fig.2 zeigt einen Querschnitt durch die Flachbaugruppe gemäß Figur 1.

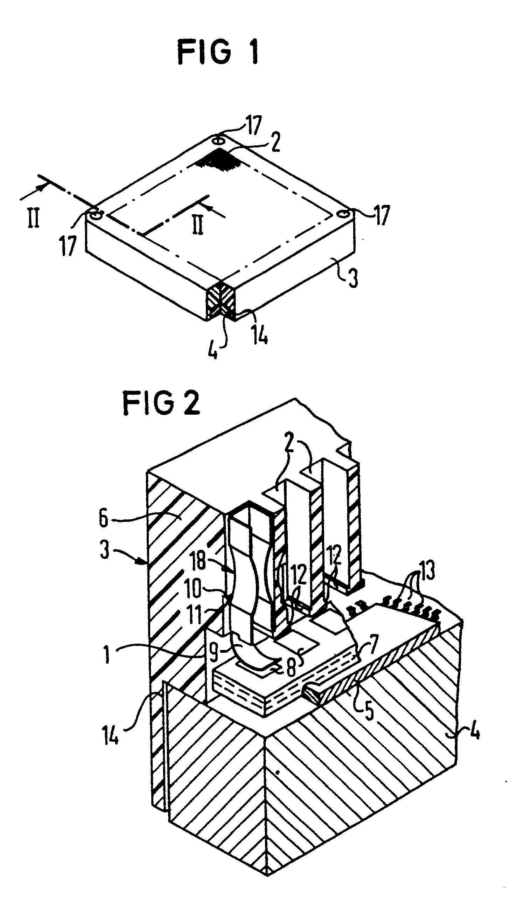

Die Flachbaugruppe, wie sie in Figur 1 dargestellt ist, ist in ihrer äußeren Form von einem plattenartigen Steckverbinderteil 3 bestimmt, welches mit einer ersten und einer zweiten, sich zu einer der Flachseiten hin öffnenden Aussparung 1, 14 zur Aufnahme einer Leiterplatte 7 bzw. eines mit Schraubverbindungen 17 befestigten Andruckbauteils 4 versehen ist. Dieses kann beispielsweise aus einer Metallplatte bestehen, die als Kühleinrichtung für die wärmeabgebenden Komponenten der Flachbaugruppe dient. Das Steckverbinderteil 3 weist in seiner Basis 6 im Bereich der ersten Aussparung 1 eine Vielzahl von rasterartig verteilten, rechteckigen Durchbrüchen 2 für Kontaktelemente 9, 18 auf, und bildet mit dem durch die Aussparung 1, 14 entstehenden Kragen eine Einfassung der Flachbaugruppe.

Figur 2 zeigt einen Querschnitt durch die Flachbaugruppe entlang der strichpunktierten Linie II in Figur 1. In einem Durchbruch 2 ist mit einer Einschnappverriegelung ein Kontaktelement 9, 18, bestehend aus einem Federschaft 18 und einer als Druckfeder ausgebildeten Anschlußfahne 9, fixiert. Der Federschaft 18 besteht aus drei U-förmig miteinander verbundenen, einen Aufnahmekanal für einen Kontaktstift (nicht dargestellt) bildenden Seitenteilen, wobei die beiden U-Schenkel gewölbte, den Aufnahmekanal trichterförmig verengende, federnde Mittelabschnitte aufweisen. Sie erzeugen bei der Aufnahme eines Kontaktstiftes einen doppelten Anpreßkontakt. Die U-Schenkel sitzen vor den Innenöffnungen der Durchbrüche 2 auf ersten Nasen 12 auf. Zur Verriegelung des Kontaktierungselementes 9, 18 spreizt sich vom Federschaft 18 eine zur Außenöffnung der Durchbrüche 2 gerichtete Zunge 11 ab, die hinter einer zweiten Nase 10 im Durchbruch 2 eingerastet ist.

Die Anschlußfahne 9 besteht aus einer gekrümmten Blattfeder, deren Krümmungsradius und Blattbreite so bemessen sind, daß das gesamte Kontaktelement 9, 18 in einen Durchbruch 2 steckbar ist. Das Blatt ist deshalb nicht breiter wie der Durchbruch 2, und der Krümmungsdurchmesser entspricht etwa der Länge des Durchbruchs 2, wobei zu berücksichtigen ist, daß sich der Krümmungsdurchmesser unter Druck verringern kann. Das freie Ende der Blattfeder ragt in die erste Aussparung 1 hinein und erzeugt einen senkrecht wirkenden Federdruck auf die darin bezüglich der Seitenkanten genau eingepaßte Leiterplatte 7.

Auf diese sind unterhalb der Durchbrüche 2 Kontaktierungsflächen 8, auf welche die Anschlußfahne, 9 pressen, gleichmäßig verteilt aufgeätzt. Die Anschlußfahnen 9 können damit über eine Lötverbindung auch fest verbunden sein. Auf der gegenüberliegenden Seite sind eine Vielzahl von integrierten Mikrobausteinen 5, von welchen einer dargestellt ist, über Anschlußdrähte 13 mittels einer Filmmontagetechnik ankontaktiert. Zu ihrer Verbindung untereinander und zu den Kontaktierungsflächen 8 verlaufen mehrere Schichten von geätzten Leiterbahnen in der Leiterplatte 7.

Über das Andruckbauteil 4 wird ein Druck auf die Bausteine 5 ausgeübt, beispielsweise um einen guten Wärmekontakt zu erzeugen, der auf die Leiterplatte 7 übertragen wird und zu einer Durchbiegung führen würde, wenn er nicht vom Federdruck der Anschlußfahnen aufgehoben würde. Eine ausreichende und gleichmäßige Kraft zwischen den Anschlußfahnen 9 und den Kontaktierungsflächen 8 wird dadurch erreicht, daß die Anschlußfahnen 9 vor der Montage überdehnt werden. Die Anschlußfahnen 9 bzw. die Kontaktelemente 9, 18 sind dabei so verteilt, daß ein gleichmäßiger Flächendruck auf die Leiterplatte 7 erzeugt wird. Außerdem wird auf diese Weise eine elastische Verbindung zwischen dem Steckverbinderteil 3 und der Leiterplatte 7 hergestellt.

**Patentansprüche** ·

1. Flachbaugruppe, bestehend aus einer mit elektrischen Bausteinen (5) bestückten Leiterplatte (7), aus einem Steckverbinderteil (3) mit einer Vielzahl von Kontaktelementen (9, 18) und aus einem, einen Druck auf eine Leiterplattenfläche in Richtung des Steckverbinderteils (3) ausübenden Andruckbauteil, beispielsweise einer Kühleinrichtung, dadurch gekennzeichnet, daß auf der dem Andruckbauteil (4) gegenüberliegenden Seite der Leiterplatte (7) Kontaktierungsflächen (8) gleichmäßig verteilt angeordnet sind, daß sich das Steckverbinderteil (3) über diese gesamte Seitenfläche erstreckt, daß es oberhalb der Kontaktierungsflächen Durchbrüche (2) für die Kontaktelemende (9,18) aufweist, die jeweils aus einem Federschaft (18) und aus einer als Druckfeder ausgebildeten, unter Federspannung an den Kontaktierungsflächen (8) anliegenden Anschlußfahne (9) bestehen.

2. Flachbaugruppe nach Anspruch 1, dadurch gekennzeichnet, daß die Anschlußfahnen (9) als gekrümmte Blattfedern ausgebildet sind.

3. Flachbaugruppe nach einem der vorhergehenden Ansprüche, dadurch gekennzeichnet, daß die Anschlußfahnen (9) fest mit den Kontaktierungsflächen (8) verbunden sind.

4. Flachbaugruppe nach einem der vorhergehenden Ansprüche, dadurch gekennzeichnet, daß die Federschäfte (18) jeweils aus drei U-förmig miteinander verbundenen, einen Aufnahmekanal für einen Kontaktstift bildenden Seitenteilen bestehen, und daß mindestens einer der U-Schenkel einen federnden Abschnitt zum Anpressen an den Kontaktstift aufweist.

5. Flachbaugruppe nach einem der vorhergehenden Ansprüche, <u>dadurch gekennzeichnet</u>, daß die Federschäfte (18) jeweils durch eine Einschnappverriegelung in den Durchbrüchen (2) fixiert sind.

6. Flachbaugruppe nach einem der vorhergehenden Ansprüche, <u>dadurch gekennzeichnet</u>, daß die Anschlußfahnen (9) bezüglich ihrer Abmessungen so ausgebildet sind, daß das gesamte Kontaktelement (9, 18) in einen Durchbruch (2) steckbar ist.

7. Flachbaugruppe nach einem der vorhergehenden Ansprüche, <u>dadurch gekennzeichnet</u>, daß die Leiterplatte (7) in eine erste Aussparung (1) des Steckverbinderteils (3) eingepaßt ist.

8. Flachbaugruppe nach Anspruch 7, <u>dadurch gekennzeichnet</u>, daß das Andruckbauteil (4) in eine zweite Aussparung (14) parallel zur Leiterplatte (7) in das Steckverbinderteil (3) eingepaßt ist.

## Claims

1. A flat assembly consisting of a printed circuit board (7) equipped with electrical modules (5), a plug connector component (3) having a plurality of contact elements (9, 18) and a pressure component, for example a cooling device, which exerts a pressure on a surface of the printed circuit board in the direction of the plug-connector component (3), <u>characterised in</u> that on the side of the printed circuit board (7) which is opposite to the pressure component (4), contacting surfaces (8) are uniformly distributed; that the plug-connector component (3) extends over this entire lateral surface; that above the contacting surfaces the component (3) has openings (2) for the contact elements (9, 18) which in each case consist of a spring shaft (18) and a contact lug (9) which is in the form of a pressure spring and abuts against the contacting surface under spring tension.

2. A flat assembly as claimed in Claim 1, <u>characterised in</u> that the contact lugs (9) are in the form of bent leaf springs.

3. A flat assembly as claimed in one of the preceding Claims, <u>characterised in</u> that the contact lugs (9) are fixedly connected to the contacting surfaces (8).

4. A flat assembly as claimed in one of the preceding Claims, <u>characterised in</u> that the spring shafts (18) in each case consist of three lateral parts connected to one another so as to form a U-shape and which form a receiving channel for a contact pin; and that at least one of the arms of the U has a resilient section for pressing against the contact pin.

5. A flat assembly as claimed in one of the preceding Claims, <u>characterised in</u> that the spring shafts (18) are in each case fixed in the openings (2) by a snap locking mechanism.

6. A flat assembly as claimed in one of the preceding Claims, <u>characterised in</u> that as regards their dimensions, the contact lugs (9) are so designed that the whole contact element (9, 18) can be plugged into one opening (2).

7. A flat assembly as claimed in one of the preceding Claims, <u>characterised in</u> that the printed circuit board (7) fits into a first recess (1) in the plug-connector component (3).

8. A flat assembly as claimed in Claim 7, <u>characterised in</u> that the pressure component (4) fits into a second recess (14) of the plug connecting component (3) parallel to the printed circuit board (7).

## Revendications

1. Module plat constitué d'une carte à circuits imprimés (7) garnie de composants électriques (5), d'une partie d'un connecteur à enfichage (3), portant un grand nombre d'éléments de contact (9, 18), et d'une pièce de pression, formée par exemple par un dispositif de refroidissement, qui exerce une pression en direction de la partie du connecteur (3) sur une face de la carte à circuits imprimés, caractérisé en ce que des aires de contact (8) sont uniformément réparties sur le coté de la carte imprimée (7) se trouvant à l'opposé de la pièce de pression (4), que la partie du connecteur (3) s'étend sur toute cette face latérale et que cette partie du connecteur présente, au-dessus des aires de contact, des alvéoles (2) pour les éléments de contact (9, 18), constitués chacun d'un fût élastique (18) et d'un talon de connexion (9) réalisé comme un ressort de pression et s'appliquant élastiquement contre une aire de contact (8).

2. Module selon la revendication 1, caractérisé en ce que les talons de connexion (9) sont réalisés comme des ressorts à lame courbes.

3. Module selon une des revendications précédentes, caractérisé en ce que les talons de connexion (9) sont reliés de façon fixe aux aires de contact (8).

4. Module selon une des revendications précédentes, caractérisé en ce que les fûts élastiques (18) sont formés chacun de trois parties latérales reliées entre elles en U et formant un canal récepteur pour une broche de connexion et que l'une au moins des branches du U presente un tronçon elastique destiné à être pressé contre la broche de contact.

5. Module selon une des revendications précédentes, caractérisé en ce que les fûts élastiques (18) sont fixés chacun dans une alvéole (2) par un verrouillage à encliquetage.

6. Module selon une des revendications précédentes, caractérisé en ce que les talons de connexion (9) sont dimensionnés de manière que tout l'élément de contact (9, 18) puisse être inséré dans une alvéole (2).

7. Module selon une des revendications précédentes, caractérisé en ce que la carte imprimée (7) est ajustée dans un premier évidement (1) de la partie du connecteur (3).

8. Module selon la revendication 7, caractérisé en ce que la pièce de pression (4) est ajustée, parallèlement à la plaque imprimée (7), dans un second évidement (14) de la carte du connecteur (3).

# FIG 1

# FIG 2